Europäisches Patentamt

European Patent Office

Office européen des brevets

(11) Veröffentlichungsnummer: **0 475 509 A1**

# EUROPÄISCHE PATENTANMELDUNG

(21) Anmeldenummer: **91202236.5**

(22) Anmeldetag: **03.09.91**

(51) Int. Cl.5: **H03J 1/00**

(30) Priorität: **08.09.90 DE 4028565**

(43) Veröffentlichungstag der Anmeldung:
**18.03.92 Patentblatt 92/12**

(84) Benannte Vertragsstaaten:
**DE ES FR GB IT**

(71) Anmelder: **Philips Patentverwaltung GmbH
Wendenstrasse 35 Postfach 10 51 49
W-2000 Hamburg 1(DE)**

(84) **DE**

(71) Anmelder: **N.V. Philips' Gloeilampenfabrieken**

Groenewoudseweg 1
NL-5621 BA Eindhoven(NL)

(84) **ES FR GB IT**

(72) Erfinder: **Schöffel, Peter, Dr.-Ing.
Baumäcker 11
W-8551 Kirchrüsselbach(DE)**

(74) Vertreter: **Volmer, Georg et al
Philips Patentverwaltung GmbH
Wendenstrasse 35, Postfach 10 51 49
W-2000 Hamburg 1(DE)**

(54) **Funkgerät mit einem Oszillator mit Phasenregelkreis.**

(57) Bekannt sind Funkgeräte mit Oszillatoren mit Phasenregelkreisen, bei denen im Phasenregelkreis Teiler angeordnet sind, denen Binärwerte zur Einstellung eines variablen Teilungsverhältnisses zugeführt werden. Um bei einem solchen Phasenregelkreis Frequenzänderungen im Betrieb des Oszillators einfach auszuführen schlägt die Erfindung vor, eine Anordnung von Registern (21-27), denen Daten getrennt zuführbar sind, vorzusehen, wobei die Ausgänge der Register über einen Addierer (40) dem Teiler (45) zugeführt sind. Anwendungsgebiet der Erfindung sind beispielsweise Funkgeräte.

Die Erfindung betrifft ein Funkgerät mit einem Oszillator mit Phasenregelkreis und mindestens einem in dem Phasenregelkreis angeordneten Teiler, dem ein Binärwert zur Einstellung eines variablen Teilungsverhältnisses zugeführt werden kann.

Phasenregelkreise (Phase locked loop, PLL) werden zur Nachlaufsynchronisation verwendet, um die Frequenz eines Oszillators so einzustellen, daß sie phasenstarr an eine Bezugsfrequenz gekoppelt ist. Hierzu wird der Oszillator so nachgeregelt, daß zwischen den beiden Takten eine vorgegebene Phasenbeziehung eingehalten wird. Anstelle des direkten Vergleichs von Oszillatortakt und Bezugstakt werden häufig auch durch Teilung abgeleitete Takte verwendet. Durch geeignete Wahl der Teilungsverhältnisse können auf diese Weise unterschiedliche Ausgangsfrequenzen des Oszillators eingestellt werden. Hauptsächlich werden solche Phasenregelkreise in Funkgeräten eingesetzt, wo sie zur Einstellung der Frequenzen verschiedener Kanäle verwendet werden.

Aus der US-PS 4,654,859 ist ein Oszillator mit Phasenregelkreis bekannt, bei dem ein im Phasenregelkreis angeordneter programmierbarer Teiler über Datenleitungen mit einem Mikroprozessor verbunden ist. Das für eine jeweilige Ausgangsfrequenz benötigte Teilungsverhältnis wird mittels des Mikroprozessors entsprechend am programmierbaren Teiler eingestellt.

Durch die Programmierbarkeit eines Teilers ist man in der Wahl der Ausgangsfrequenzen sehr flexibel. Oftmals müssen jedoch Teilungsverhältnisse eingestellt werden, zu deren Darstellung eine große Anzahl von Binärstellen benötigt werden.

Aufgabe der Erfindung ist es, einen Phasenregelkreis der eingangs genannten Art so auszugestalten, daß Frequenzänderungen im Betrieb des Oszillators einfach ausführbar sind.

Diese Aufgabe wird dadurch gelöst, daß eine Anordnung von Registern, die zur Zuführung von Daten vorgesehen sind, mit dem Teiler über einen Addierer gekoppelt sind.

Die Wortbreite der einzelnen Register kann auf diese Weise geringer gewählt werden als die zur Darstellung des gewählten Teilungsverhältnisses benötigte Stellenanzahl. Durch Kaskadierung von Registern kann ein erster Binärwert erhalten werden, zu welchem ein zweiter Binärwert addiert werden kann. Die Summe beider Binärwerte ergibt das jeweilige Teilungsverhältnis. In vorteilhafter Weise können die Binärwerte der einzelnen Register so gewählt werden, daß zur Umschaltung auf eine andere Frequenz lediglich der Inhalt eines einzigen Registers zu ändern ist. Dies bietet den Vorteil, daß die Umprogrammierung zur Erzielung eines neuen Teilungsverhältnisses beispielsweise nur auf ein Register beschränkt werden kann und somit schneller ausgeführt werden kann als die erneute Programmierung eines neuen Teilungsverhältnisses.

Besonders bei Funksystemen, bei denen mehrere Funkkanäle in einem festen Kanalabstand voneinander gewählt sind, bietet die Erfindung die Möglichkeit, nach einmaliger Programmierung eines bestimmten Grundteilungsverhältnisses, beispielsweise jedesmal beim Einschalten des Funkgerätes, lediglich durch Vorgabe einer gewünschten Kanalnummer die Ausgangsfrequenz des Oszillators auf die für die bestimmte Kanalnummer benötigte Ausgangsfrequenz einzustellen. Hierdurch verringert sich auch der interne Aufwand im Funkgerät zur Umrechnung von Kanalnummern in Teilungsverhältnisse. Ein Kanalwechsel ist somit schneller durchführbar.

In einer weiteren Ausgestaltung der Erfindung ist den Registern und dem Addierer ein Multiplexer zwischengeschaltet. Durch den Multiplexer kann zwischen zwei verschiedenen Teilungsverhältnissen, beispielsweise für Sende- und Empfangsfrequenzen, umgeschaltet werden. Unabhängig von der Programmierung des Registers, das zur Frequenzeinstellung dient, bleibt die Differenz zwischen den beiden Ausgangsfrequenzen des Oszillators, die sich durch den Multiplexer auswählen lassen, jeweils konstant. Auf diese Weise kann bei den obenstehend genannten Funksystemen, bei denen zwischen Empfangsfrequenz und Sendefrequenz ein für alle Kanäle konstanter Frequenzabstand vorgesehen ist, allein durch Umprogrammierung der Kanalnummer nach entsprechender Umschaltung des Multiplexers jeweils die benötigte Frequenz für den Empfangsteil bzw. Sendeteil ohne weiteren zusätzlichen Programmieraufwand erhalten werden. Die Menge der auszutauschenden Daten wird auf diese Weise äußerst gering gehalten.

Die Erfindung wird nun anhand eines Ausführungsbeispiels näher beschrieben und erläutert.

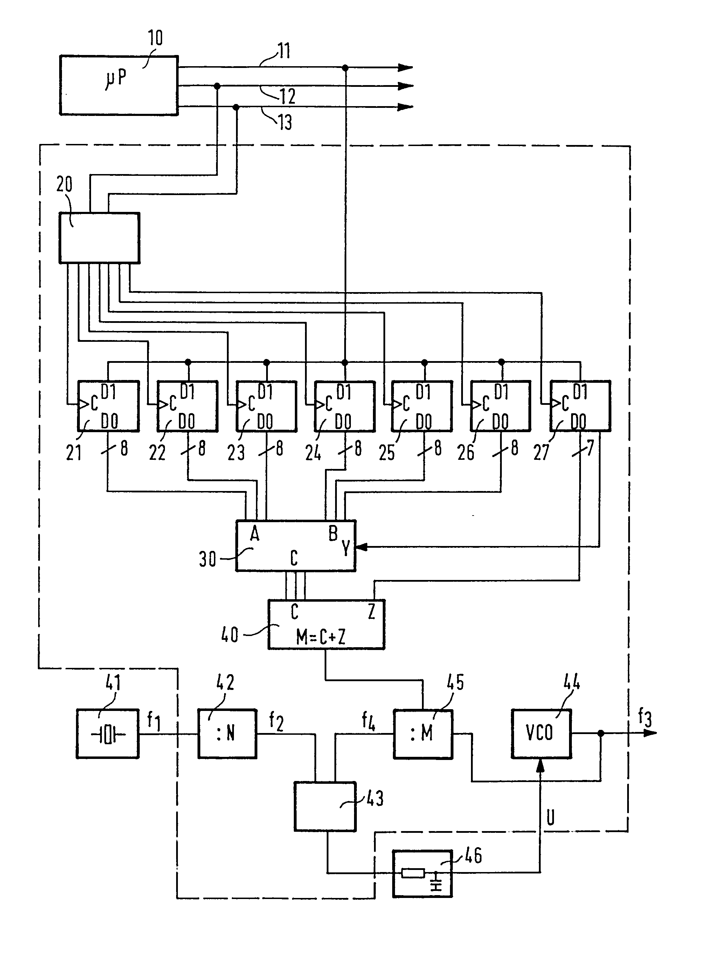

Die einzige Figur zeigt einen Oszillator mit einer Phasenregelschleife, in der ein programmierbarer Teiler angeordnet ist.

Im Ausführungsbeipiel wird der Oszillator mit Phasenregelkreis in einen Funkempfänger zur Erzeugung einer ersten Mischfrequenz zum Empfang eines Funksignals bzw. zur Erzeugung einer Sendefrequenz, die einem Sendemodulator zugeführt ist, eingesetzt. Der Funkempfänger wird in einem Funksystem eingesetzt, bei dem 124 Funkkanäle verwendet werden, die einen Kanalabstand von 200 KHz aufweisen. Die niedrigste Mischfrequenz, die dem Empfangskanal 1 entspricht, ist 935,2 MHz. Die niedrigste Sendefrequenz, die dem Sendekanal 1 entspricht, ist auf 890,2 MHz festgelegt.

Ein Bezugstaktoszillator 41 liefert einen Bezugstakt $f_1$, welcher durch einen ersten Teiler 42 durch den Faktor N auf eine zweite Frequenz $f2$

geteilt wird. Der Teilungsfaktor N ist im Ausführungsbeispiel so gewählt, daß die nach der Teilung bereitstehende abgeleitete Bezugsfrequenz f2 genau dem Kanalabstand zweier benachbarter Empfangs- bzw. Sendekanäle entspricht. Bei einem gewählten Bezugtakt von 13 MHz und einem Kanalabstand von 200 KHz ist somit der Teilungsfaktor N gleich 65.

Ein spannungsgesteuerter Oszillator (VCO) 44 erzeugt eine Ausgangsfrequenz f3, die einem programmierbaren Teiler 45 zugeführt ist. Die nach Teilung durch einen Faktor M geteilte VCO-Ausgangsfrequenz f4 ist, wie die geteilte Bezugsfrequenz f2, einem Phasendiskriminator 43 zugeführt. Der Phasendiskriminator 43 erzeugt mittels eines Tiefpaßfilters 46 eine der Phasenabweichung proportionale Steuerspannung U, die dem spannungsgesteuerten Oszillator 44 zugeführt ist und dessen Ausgangsfrequenz f3 gemäß der Beziehung

$$f3 = \frac{M}{N} * f1 \qquad (1)$$

einstellt.

Entsprechend der gewünschten Ausgangsfrequenz des spannungsgesteuerten Oszillators 44 ist das Teilungsverhältnis M zu wählen. Hierzu ist an einem Datenbus 11 eines Mikroprozessors 10 eine Anordnung von sieben Registern 21 bis 27 vorgesehen. An einem Adreßbus 12 und einem Kontrollbus 13 des Mikroprozessors 10 ist ferner ein Adreßdecodierer 20 angeschlossen. Vom Adreßdecodierer 20 führt getrennt für jedes Register jeweils eine Steuerleitung an Steuereingänge der Register. Jedem der Register 21 bis 27 ist mittels des Adreßdecodierers 20 eine bestimmte Adresse zugeordnet. Erkennt der Adreßdecodierer 20 eine einem der Register 21 bis 27 zugeordnete Adresse, so erzeugt er auf der betreffenden, zu diesem Register führenden Steuerleitung ein Übernahmesignal. Auf diese Weise kann der Mikroprozessor 10 je nach Wahl jedem der Register 21 bis 27 ein achtstelliges Binärwort einschreiben. Die Datenübertragung dieser Binärworte kann je nach verwendeter Busarchitektur sowohl wortweise (z.B. 8 bit-breite Datenwörter) als auch seriell (z.B. mittels I²C-Bus) erfolgen.

Im Ausführungsbeispiel sind die Register so organisiert, daß durch die Registerinhalte der ersten drei Register 21, 22, 23 ein vierundzwanzigstelliges Binärwort A darstellbar ist, welches zur Bildung des Teilungsfaktors M für die Mischfrequenz des Empfangsteils verwendet wird. Die nächsten drei Register 24, 25, 26 dienen zur Darstellung eines vierundzwanzigstelligen Binärwertes B, aus dem der Teilungsfaktor M für die Sendefrequenz abgeleitet wird. Mittels eines Multiplexers 30 kann zwischen diesen beiden Binärworten A, B ausgewählt werden. Das ausgewählte Binärwort C ist einem Addierer 40 zugeführt. Die sieben niederwertigsten Bits des siebten Registers 27 sind als Kanalwahlwort Z ebenfalls dem Addierer 40 zugeführt. In dem Addierer 40 werden das vierundzwanzigstellige ausgewählte Binärwort C und das siebenstellige Kanalwahlwort Z addiert und auf diese Weise der Teilungsfaktor M für den programmierbaren Teiler 45 erhalten. Die Auswahl zwischen den beiden vierundzwanzigstelligen Binärwerten A bzw. B erfolgt mit dem verbleibenden höherwertigsten achten Bit Y des siebten Registers 27. Dieses Bit Y ist einem Steuereingang des Multiplexers 30 zugeführt.

Je nach Zustand des Steuerbits Y erhält man auf diese Weise eine Mischerfrequenz f3 gemäß der Beziehung

$$f3 = f1 * \frac{A + Z}{N} \qquad (2)$$

bzw. eine Sendefrequenz

$$f3 = f1 * \frac{B + Z}{N} \qquad (3) .$$

Im Ausführungsbeispiel, bei dem die niedrigste Mischfrequenz f3 für eine Kanalnummer 1 bei 935,2 MHz liegt, ist somit unter Zugrundelegung der zu 200 KHz gewählten Bezugsfrequenz und dem Kanalwahlwort Z = 1 für das erste Binärwort A der dezimale Zahlenwert 4 675 vorzusehen. Dieser Wert ist in die ersten drei Register 21, 22, 23 zu laden. Bei einer Sendefrequenz von 890,2 MHz für einen Sendekanal 1 ist der in die zweiten drei Register 24, 25, 26 zu ladende zweite Binärwert B gleich dem digitalen Zahlenwert 4 450 zu wählen. Zur binären Darstellung dieser Teilungsverhältnisse werden mehr als acht Bit benötigt, während zur Darstellung von 124 Kanälen lediglich siebenstellige Binärzahlen erforderlich sind.

Im Ausführungsbeispiel sind die Register 21 bis 27 als RAM-Bausteine ausgeführt, so daß sie beliebig oft umprogrammiert werden können. Dies erhöht die Flexibilität der beschriebenen Anordnung. Hierzu ist es jedoch erforderlich, daß beispielsweise beim Einschalten des Funkempfängers zunächst die vierundzwanzigstelligen Binärwerte A bzw. B vorprogrammiert werden. Zum Kanalwechsel ist in der weiteren Anwendung lediglich der Inhalt des siebten Registers 27 zu ändern.

Eine noch größere Flexibilität erhält man dadurch, daß auch das Teilungsverhältnis N des ersten Teilers programmierbar ausgeführt wird. Hierdurch sind dann nicht nur die Sende- und Empfangsfrequenzen änderbar, sondern auch die Kanalabstände. Vom Schutzumfang umfaßt sollen aber auch Anwendungen sein, bei denen beispielsweise die ersten sechs Register 21 bis 26 beispielsweise aus Festwertspeichern gebildet sind und lediglich der Inhalt des siebten Registers verändert werden kann.

Besonders vorteilhaft ist es, den Adreßdecodierer 20, die Register 21 bis 27, den Multiplexer 30, den Addierer 40 zusammen mit Teilen des Phasenregelkreises, beispielsweise den ersten Teiler 42 und den programmierbaren Teiler 45 sowie den Phasendiskriminator 43 und den spannungsgesteuerten Oszillator 44, auf einer einzigen integrierten Schaltung zusammenzufassen. Hierdurch erhält man einen sehr universell einsetzbaren Schaltkreis für eine Phasenregelschleife, die sich vielseitig verwenden läßt.

## Patentansprüche

1. Funkgerät mit einem Oszillator mit Phasenregelkreis und mindestens einem in dem Phasenregelkreis angeordneten Teiler, dem ein Binärwert zur Einstellung eines variablen Teilungsverhältnisses zugeführt werden kann,
   dadurch gekennzeichnet,
   daß eine Anordnung von Registern (21 bis 27), die zur Zuführung von Daten vorgesehen sind, mit dem Teiler (45) über einen Addierer (40) gekoppelt sind.

2. Funkgerät nach Anspruch 1,
   dadurch gekennzeichnet,
   daß zwischen den Registern (21 bis 27) und dem Addierer (40) ein Multiplexer (30) angeordnet ist.

3. Funkgerät nach Anspruch 2,
   dadurch gekennzeichnet,
   daß ein Ausgang, vorzugsweise das höchstwertigste Bit, eines Registers (27) einem Steuereingang des Multiplexers (30) zugeführt ist.

4. Funkgerät nach einem der Ansprüche 1, 2 oder 3,
   dadurch gekennzeichnet,
   daß die Register an einem Datenbus (11) angeschlossen sind und zum Einschreiben von Daten jeweils ein bestimmtes Register ansteuerbar ist.

5. Funkgerät nach einem der Ansprüche 1 bis 4,
   dadurch gekennzeichnet,
   daß zumindest die Register (21 bis 27), der Addierer (40) und Teile des Phasenregelkreises (42, 43, 45) auf einem gemeinsamen Schaltkreis integriert sind.

6. Funkgerät nach einem der Ansprüche 1, 2, 3, 4 oder 5,
   dadurch gekennzeichnet,
   daß der Oszillator Teil eines Funksendeempfangsgerätes ist.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X,P | PATENT ABSTRACTS OF JAPAN vol. 15, no. 58 (E-1032)12. Februar 1991 & JP-A-22 085 812 ( ALPS ELECTRIC CO LTD ) 26. November 1990 * Zusammenfassung * * | 1,6 | H 03 J 1/00 |
| X | EP-A-0 009 617  (SANYO ELECTRIC CO.) * Seite 8, Zeile 4 - Seite 20, Zeile 13; Abbildungen 1-2 * * | 1 | |
| Y | | 6 | |
| X | PATENT ABSTRACTS OF JAPAN vol. 9, no. 189 (E-333)6. August 1985 & JP-A-60 058 711 ( SANYO DENKI KK ) * Zusammenfassung * * | 1 | |
| Y | | 6 | |
| Y | DE-A-2 552 177  (ROBERT BOSCH GMBH) * Seite 7, Zeile 1 - Seite 12, Zeile 5; Abbildungen 1,2 * * | 6 | |

RECHERCHIERTE SACHGEBIETE (Int. Cl.5)

H 03 J
H 03 L

Der vorliegende Recherchenbericht wurde für alle Patentansprüche erstellt

| Recherchenort | Abschlußdatum der Recherche | Prüfer |
|---|---|---|
| Den Haag | 12 Dezember 91 | BALBINOT H. |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus anderen Gründen angeführtes Dokument

&: Mitglied der gleichen Patentfamilie, übereinstimmendes Dokument